# EUROPEAN PATENT SPECIFICATION

(11) **EP 3 594 792 B1**
(45) Date of publication and mention of the grant of the patent: **03.08.2022**
(21) Application number: 19184287.1
(22) Date of filing: 04.07.2019
(51) Int. Cl.: G06F 3/044, G06F 3/02, F25D 23/02, H03K 17/96

(54) **A TOUCH CONTROL SYSTEM**
BERÜHRUNGSSTEUERUNGSSYSTEM
SYSTÈME DE COMMANDE TACTILE

(30) Priority: 13.07.2018 TR 201810033
(43) Date of publication of application: 15.01.2020
(73) Proprietor: Vestel Beyaz Esya Sanayi ve Ticaret A.S., 45030 Manisa (TR)
(72) Inventor: OZERTUG, Burak, 45030 Manisa (TR); OZKAN, Umut, 45030 Manisa (TR); YAMAN, Melih, 45030 Manisa (TR)
(74) Representative: Cayli, Hülya

(56) References cited:
- EP-A1- 3 037 759
- EP-A1- 3 154 200
- KR-A- 20130 027 987
- US-A1- 2010 296 303
- US-A1- 2011 134 627
- US-A1- 2016 306 482
- US-A1- 2018 135 333

## Description

### Technical Field

The present invention relates to a touch control system suitable for use in household appliances.

### Prior Art

Today, the touch control feature replaces the conventional control buttons in ovens, dishwashers, refrigerators and such household appliances. According to said applications, various control icons are commonly provided on a door panel of the appliance, and a user contacts these icons, by means of a touch button associated with the relevant icon, to to perform a control operation regarding the relevant icon. According to applications stated, the touch buttons may comprise various sensors in connection with an electronic circuit to detect proximity or touch (generally, a touch with a finger) of a user according to capacitance difference created, and to perform the function associated with the relevant icon provided on the panel.

In the household appliances stated, the user may be provided with a feedback concerning the control functions by means of a visual feedback means (e.g. a light screen, a light warning unit associated with the touch button, etc.). Under normal circumstances, the feedback may be provided such that any feedback means located behind the panel is invisible from outside, but it becomes visible when activated (dead-front). The feature that the means located behind the panel is invisible under normal circumstances (dead-front) is generally performed by a semi-transparent outer panel. While the outer panel prevents the feedback means, which is located therein, from being visible under normal circumstances, it allows light of the lighting units of the feedback means to be passed and makes the light visible by activation of the feedback device. However, using a semi-transparent outer panel causes difficulties in terms of production and may increase the costs.

Patent document no. US2011134627A1 discloses appliance doors having integrated lighting and controls. According to this document, the integrated controls are incorporated into a polycarbonate clear door panel, and incorporate proximity switches and controls to provide control and operation of the appliance. Light emitting diodes (LEDs) are optionally incorporated into a door handle for the appliance in an area out of sight such that only the light produced by the LEDs is seen and illuminates a handle for opening the door of the appliance. Additionally, opaque glass technology may be incorporated into one or more surfaces of the appliance which enables an opaque panel to become transparent to view the content of the interior of the appliance, such as a refrigerator.

Another patent document no. US2010296303A1t discloses dead front actuating assembly. Said dead front actuating assembly comprises a first layer having at least one selectively illuminated area, and a second layer having a plurality of sensors used for activating the at least one selectively illuminated area such that the at least one selectively illuminated area becomes illuminated, and the first layer is adjacent to the second layer.

Another patent document no. US2018135333A1 discloses a household appliance having a display at a pocket handle. Said household appliance comprises a cabinet defining a chamber with an access opening, a door movably mounted to the cabinet to selectively open and close the access opening and having a face, and a pocket handle having a recess provided in the door with an ingress opening to define a pocket, and a display provided with the door and overlying a portion of the pocket to define a handle pull, wherein a user can insert their fingers into the pocket through the ingress opening and pull against the handle pull to move the door to open the access opening.

Another patent document no. KR20130027987A discloses a refrigerator. Said refrigerator comprises a main control unit and a sub-controller. The main controller controls a blower blowing the cool air inside of the refrigerator and a compressor comprising a refrigeration cycle. The sub-controller is arranged on the door surface of the front side comprises an input unit having an electrostatic touch sensor and a display unit indicating a manipulating result from multiple switch electrodes of the electrostatic touch sensor. At least one from the multiple switch electrodes has an electrode on the front side and the rear side of the substrate installed with the switch electrodes and the switches on the front and the rear side are electrically connected.

Another patent document no. EP3037759A1 discloses a household appliance with a touch sensor. Said household appliance comprises a front panel forming an exterior, a display window formed with a plurality of through holes having minute or fine sizes formed at the front panel, and the plurality of through holes are filled with a coating liquid including an anti-foaming agent.

Another patent document no. EP3154200A1 discloses a capacitive switch circuit. Said circuit comprises a cover plate arranged in a housing, which is made of a transparent or semi-transparent material; at least one sensor area generating a capacitance field, which is made of an electrically conductive material and which is applied to a carrier or printed circuit board provided on the inside of the housing and which is aligned with the respective button is aligned; lighting means for generating light waves which run in a beam path directed towards the cover plate and through which the respective button is illuminated; a voltage source for energizing the sensor surface and the lighting means, a thin-walled reflection screen located in the beam path of the respective light wave of the illuminating means wherein the light waves emitted by the illuminating means in the direction of the reflective screen pass through it to the outside pass through and that the light waves incident on the outside of the reflection screen are partially reflected, refracted and / or scattered by the them.

### Brief Description of the Invention

The touch control system according to the present invention is suitable for use in a household appliance which comprises at least one body; at least one chamber provided in an interior part of the body; at least one door which controls access to the chamber by being opened and closed and has a front surface facing the outer environment and a rear surface facing the chamber; at least one control panel controlling functions of the household appliance and embedded in the door; and at least one mounting hole provided at a front part of the control panel facing the front surface thereof; the touch control system comprising: at least one mounting unit adapted to be located at the mounting hole; at least one control module fixed to the mounting unit, having at least one capacitive sensor that senses the touch of a user and at least one light indicator that provides feedback associated with the appliance, adapted to be connected to the control panel, and sending the control commands which are received by a user touch to the control panel so as to perform said functions; at least one front panel made of a transparent material and adapted to be located at an area of the front surface of the door where at least the opening is provided; at least one elastic unit which enables the control module to be fixed to the mounting unit such that the control module is pushed towards the front surface of the door and contacts with the front panel; and at least one film which is semi-transparent and insulating, provided between the front panel and the control module, adapted to be placed between the front panel and the control module, and is a separate component than said units.

The touch control system according to the invention allows the household appliance to be controlled by a touch control from an outer part of the door thereof, and a dead-front indication is generated on the door. According to the embodiment stated, the front panel of the door is made of a transparent material such as glass and the like, and the transparent and insulating film ensures the feature of dead-front, thus eliminating the need of a semi-transparent front panel usage.

### Object of the Invention

An object of the present invention is to provide a touch control system suitable for use in household appliances and having the dead-front feature.

Another object of the present invention is to provide an easy to produce and low cost touch control system.

### Description of the Drawings

Exemplary embodiments of the touch control system according to the present invention which is suitable for use in household appliances are illustrated in the attached drawings, in which:
Figure 1 is a sectional view of the touch control system according to the invention.
Figure 2 is another sectional view of the touch control system according to the invention.

All the parts illustrated in figures are individually assigned a reference numeral and the corresponding terms of these numbers are listed below:

| | |
|---|---|
| Door | (K) |
| Front panel | (1) |
| Control panel | (2) |
| Mounting unit | (3) |
| Film | (4) |
| Control module | (5) |
| Elastic unit | (6) |

### Description of the Invention

Today, the touch control feature replaces the conventional control buttons in household appliances. According to said applications, various control icons are commonly provided on a door panel of the appliance, and a user contacts these icons to perform a control operation regarding the relevant icon. In the household appliances stated, the user may be provided with a feedback concerning said control functions by means of a visual feedback means. Under normal circumstances, the feedback can be provided with the dead-front feature in which any feedback means located behind the panel is invisible from outside, but it becomes visible when activated. The dead-front feature is generally performed by a semi-transparent outer panel; and while the outer panel prevents the feedback means, which is located therein, from being visible under normal circumstances, it allows light of the lighting units to be passed and makes the light visible by activation of the feedback device. However, using a semi-transparent outer panel causes difficulties in terms of production and may increase the costs. Therefore, the present invention provides an easy to produce and low cost touch control system which is suitable for use in household appliances and has the dead-front feature.

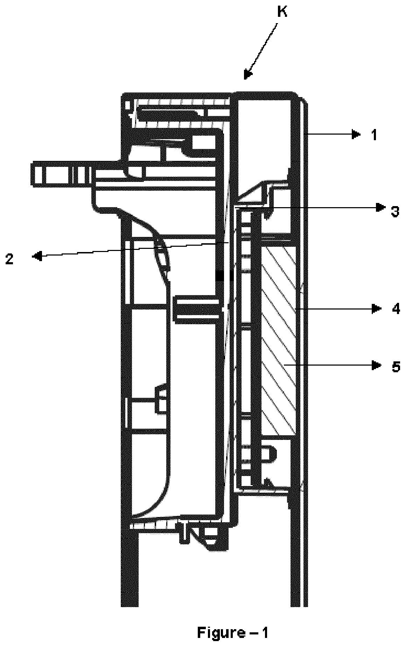

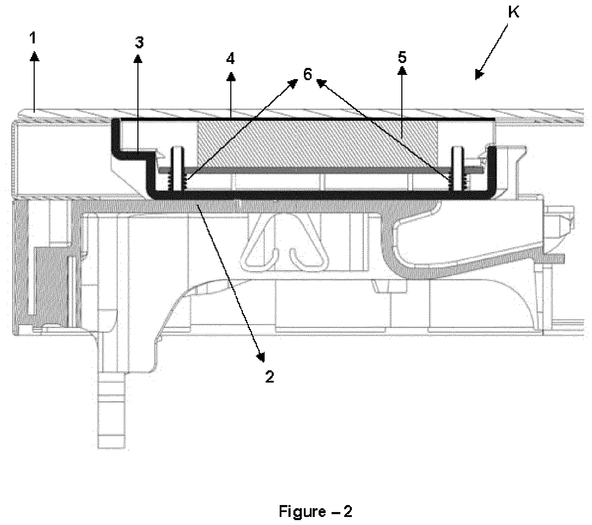

The touch control system according to the present invention, exemplary views of which are illustrated in Figure 1 - 2, is suitable for use in a household appliance (e.g. a dishwasher, a refrigerator, an oven, etc.) which comprises at least one body (not illustrated in the figures); at least one chamber (not illustrated in the figures) provided in an interior part of the body; at least one door (K) which controls access to the chamber by being opened and closed and has a front surface facing the outer environment and a rear surface facing the chamber; at least one control panel (2) controlling functions of the household appliance and embedded in the door (K); and at least one mounting hole (not illustrated in the figures) provided at a front part of the control panel (2) towards the front surface thereof (i.e. communicates with the outer environment with at least one opening provided at the front surface), the touch control system comprising: at least one mounting unit (3) adapted to be located at the mounting hole; at least one control module (5) fixed to the mounting unit (3), having at least one capacitive sensor (not illustrated in the figures) that senses the touch of a user and at least one light indicator (not illustrated in the figures) that provides feedback associated with the appliance, adapted to be connected to the control panel (2), and sending the control commands which are received by a user touch to the control panel (2) so as to perform said functions; at least one front panel (1) made of a transparent material (e.g. glass, mica and the like) and adapted to be located at an area of the front surface of the door (K) where at least the control module (5) is provided the front panel covers the whole front surface of the door (K), and at least a surface of the front panel other than the area where the opening is provided, is dyed); at least one elastic unit (6) (e.g. a spring) which enables the control module (5) to be fixed to the mounting unit (3) such that the control module (5) is pushed towards the front surface of the door (K) and contacts with the front panel (1), and which is, preferably, located between the control module (5) and the mounting unit (3); and at least one film (4) which is semi-transparent and (electrically) insulating and provided between the front panel (1) and the control module (5) (the film is adapted to be placed between the front panel (1) and the control module (5), and is a separate component than said units).

According to an exemplary embodiment of the invention, the household appliance can be controlled by the touch control feature through the front panel (1) provided at a front part of the door (K), and is able to perform functions such as on/off, program start/stop, child lock and automatic door (K) opening and the like. Furthermore, an image of an information screen is provided to the user by means of the light indicator, via the front panel (1). According to said embodiment, the control module (5) provided at the front part of the control panel (2) comprises capacitive sensors and light indicators that provide touch control and screen display functions. The control module (5) is mounted to the door (K) by the elastic unit (6) and the mounting unit (3) that is located at a mounting hole provided at the front part of the control panel (2), such that the control module (5) contacts the surface of the front panel (1) so that there is no gap in between, and that the capacitive sensors sense the user touch. Components provided in the door (K) are visible from outside since the front panel (1) is made of a transparent material. An outer surface facing the outer environment and/or an interior surface facing the door (K) of the front panel (1) other than a region corresponding to the area where the opening is provided is dyed. Together with the front panel (1) that is dyed, the semi-transparent and insulating film (4) provided between the control module (5) and the front panel (1) prevents the components inside the door (K) from being visible; therefore, allowing the front panel (1) to be seen as a dead-front as long as light indicator of the control module (5) is not activated. Since the film (4) covering the front surface of the control module (5) is made of an insulating material, capacitive sensors provided in the control module (5) are prevented from affecting each other. When the light indicator is activated, the light emitted passes through said semi-transparent film (4) and becomes visible through the front part of the front panel (1), thus creating a display image at the front part of the door (K).

According to a preferred embodiment of the invention, the mounting unit (3) is in the form of a chamber which comprises at least one housing (not illustrated in the figures). According to said embodiment, the control module (5) is received at the housing to achieve a modular structure.

According to a preferred embodiment of the invention, there are provided various symbols/signs on the film (4). According to the embodiment, the symbols/signs are provided at a part of the film (4) where the capacitive sensor and/or the light indicator are located; and comprise symbols and signs for the function of the capacitive sensor and/or symbols and signs for the notification of function performed at the appliance (e.g. type of the function, stage of the function, etc.).

The touch control system according to the invention allows the household appliance to be controlled by a touch control from an outer part of the door (K) thereof, and a dead-front indication is generated on the door (K). According to the embodiment stated, the front panel (1) of the door (K) is made of a transparent material such as glass and the like, and the transparent and insulating film (4) ensures the feature of dead-front, thus eliminating the need of a semi-transparent front panel (1) usage.

## Claims

1. A touch control system suitable for use in a household appliance which comprises at least one body; at least one chamber provided in an interior part of the body; at least one door (K) which controls access to the chamber by being opened and closed and has a front surface facing the outer environment and a rear surface facing the chamber; at least one control panel (2) controlling functions of the household appliance and embedded in the door (K); and at least one mounting hole provided at a front part of the control panel (2) facing the front surface thereof; the touch control system comprising:
- at least one mounting unit (3) adapted to be located at the mounting hole;
- at least one control module (5) fixed to the mounting unit (3), having at least one capacitive sensor that senses the touch of a user and at least one light indicator that provides feedback associated with the appliance, adapted to be connected to the control panel (2), and sending the control commands which are received by a user touch to the control panel (2) so as to perform said functions;
the touch control system **characterized by** comprising:
- at least one front panel (1) made of a transparent material and being adapted to cover the whole front surface of the door (K);
- at least one elastic unit (6) which enables the control module (5) to be fixed to the mounting unit (3) such that the control module (5) is pushed towards the front surface of the door (K) and contacts with the front panel (1); and
- at least one film (4) which is semi-transparent and insulating, and provided between the front panel (1) and the control module (5).

2. A touch control system according to claim 1, wherein the front panel (1) is glass.

3. A touch control system according to any one of the preceding claims, wherein the mounting unit (3) is in the form of a chamber which comprises at least one housing.

4. A touch control system according to any one of the preceding claims, wherein the touch control system comprises various symbols/signs provided on the film (4).

5. A touch control system according to claim 1, wherein the elastic unit (6) is located between the control module (5) and the mounting unit (3).

6. A touch control system according to claim 1, wherein at least one surface of the front panel (1), other than an area corresponding to the part where the control module (5) is provided, is dyed.

## Patentansprüche

1. Touch-Steuersystem geeignet zur Verwendung in einem Haushaltsgerät, das wenigstens ein Gehäuse, wenigstens eine in einem inneren Teil des Gehäuses vorgesehenen Kammer, wenigstens eine Tür (K), die den Zugang zu der Kammer kontrolliert, indem sie geöffnet und geschlossen wird, und die eine der äußeren Umgebung zugewandte Frontfläche und eine der Kammer zugewandte Rückfläche hat, wenigstens ein Steuerfeld (2), das Funktionen des Haushaltsgeräts steuert und das in die Tür (K) eingebettet ist, und wenigstens eine Montageöffnung aufweist, die in einem vorderen Bereich des Steuerfeldes (2), dessen Frontfläche zugewandt vorgesehen ist, wobei das Touch-Steuersystem aufweist:
- wenigstens eine Montageeinheit (3), die dazu ausgestaltet ist, um an der Montageöffnung platziert zu sein,
- wenigstens ein Steuermodul (5), das an der Montageeinheit (3) fixiert ist, das wenigstens einen kapazitiven Sensor, der die Berührung eines Benutzers erfasst, und wenigstens eine Lichtanzeige aufweist, die eine sich auf das Gerät beziehende Rückmeldung liefert, das dazu eingerichtet ist, mit dem Steuerfeld (2) verbunden zu sein und das die Steuerbefehle, die durch Berührung des Benutzers an dem Steuerfeld (2) aufgenommen werden, sendet, um so die Funktionen auszuführen,
wobei das Touch-Steuersystem **dadurch gekennzeichnet ist, dass** es aufweist:
- wenigstens eine Frontplatte (1), die aus trasparentem Material hergestellt ist und die dazu ausgestaltet ist, um die gesamte Frontfläche der Tür (K) abzudecken,
- wenigstens eine elastische Einheit (6), die das Steuermodul (5) in die Lage versetzt, an der Montageeinheit (3) fixiert zu werden, so dass das Steuermodul (5) zu der Frontoberfläche der Tür (K) hin gedrückt wird und die Frontplatte (1) kontaktiert, und
- wenigstens eine Folie (4), die semitransparent und isolierend ist und die zwischen der Frontplatte (1) und dem Steuermodul (5) vorgesehen ist.

2. Touch-Steuersystem nach Anspruch 1, wobei die Frontplatte (1) aus Glas ist.

3. Touch-Steuersystem nach einem der vorhergehenden Ansprüche, wobei die Montageeinheit (3) die Form einer Kammer hat, die wenigstens ein Gehäuse aufweist.

4. Touch-Steuersystem nach einem der vorhergehenden Ansprüche, wobei das Touch-Steuersystem verschiedene Symbole/Zeichen aufweist, die auf der Folie (4) vorgesehen sind.

5. Touch-Steuersystem nach Anspruch 1, wobei die elastische Einheit (6) sich zwischen dem Steuermodul (5) und der Montageeinheit (3) befindet.

6. Touch-Steuersystem nach Anspruch 1, wobei wenigstens eine Oberfläche der Frontplatte (1), außer einem Gebiet entsprechend des Teils, wo das Steuermodul (5) vorgesehen ist, eingefärbt ist.

## Revendications

1. Système de commande tactile adapté à être utilisé dans un appareil électroménager qui comprend au moins un corps ; au moins une chambre prévue dans une partie intérieure du corps ; au moins une porte (K) qui contrôle l'accès à la chambre en étant ouverte et fermée et a une surface avant faisant face à l'environnement extérieur et une surface arrière faisant face à la chambre ; au moins un panneau de commande (2) contrôlant des fonctions de l'appareil électroménager et intégré dans la porte (K) ; et au moins un trou de montage prévu sur une partie avant du panneau de commande (2) faisant face à la surface avant de celui-ci ; le système de commande tactile comprenant :
- au moins une unité de montage (3) adaptée pour être située au niveau du trou de montage ;
- au moins un module de commande (5) fixé à l'unité de montage (3), ayant au moins un capteur capacitif qui détecte le toucher d'un utilisateur et au moins un indicateur lumineux qui fournit un retour associé à l'appareil, adapté pour être connecté au panneau de commande (2), et envoyant les commandes de contrôle qui sont reçues par un toucher de l'utilisateur au panneau de commande (2) de manière à exécuter lesdites fonctions ;
le système de commande tactile **caractérisé en ce qu'**il comprend :
- au moins un panneau frontal (1) fait d'un matériau transparent et étant adapté pour couvrir toute la surface frontale de la porte (K) ;
- au moins une unité élastique (6) qui permet au module de commande (5) d'être fixé à l'unité de montage (3) de sorte que le module de commande (5) est poussé vers la surface avant de la porte (K) et entre en contact avec le panneau avant (1) ; et
- au moins un film (4) semi-transparent et isolant, prévu entre le panneau avant (1) et le module de commande (5).

2. Système de commande tactile selon la revendication 1, dans lequel le panneau avant (1) est en verre.

3. Système de commande tactile selon l'une quelconque des revendications précédentes, dans lequel l'unité de montage (3) se présente sous la forme d'une chambre qui comprend au moins un logement.

4. Système de commande tactile selon l'une quelconque des revendications précédentes, dans lequel le système de commande tactile comprend divers symboles/signes prévus sur le film (4).

5. Système de commande tactile selon la revendication 1, dans lequel l'unité élastique (6) est située entre le module de commande (5) et l'unité de montage (3).

6. Système de commande tactile selon la revendication 1, dans lequel au moins une surface du panneau avant (1), autre qu'une zone correspondant à la partie où le module de commande (5) est prévu, est teintée.
